# EUROPÄISCHE PATENTSCHRIFT

(11) **EP 4 454 012 B1**
(45) Veröffentlichungstag und Bekanntmachung des Hinweises auf die Patenterteilung: **08.04.2026**
(21) Anmeldenummer: 22839341.9
(22) Anmeldetag: 22.12.2022
(51) Int. Cl.: F28F 13/02, H01L 23/427, F28D 15/02, F28D 15/04, F28D 21/00

(54) **KÜHLVORRICHTUNG**
COOLING DEVICE
DISSIPATEUR DE CHALEUR

(30) Priorität: 22.12.2021 DE 102021214936
(43) Veröffentlichungstag der Anmeldung: 30.10.2024
(73) Patentinhaber: Robert Bosch GmbH, 70442 Stuttgart (DE)
(72) Erfinder: FREY, Yannick Fabian, 72072 Tuebingen (DE)
(86) Internationale Anmeldenummer: PCT/EP2022/087415
(87) Internationale Veröffentlichungsnummer: WO 2023/118405

(56) Entgegenhaltungen:
- WO-A1-2022/238086
- CN-A- 106 052 444
- US-A1- 2013 133 871
- US-A1- 2018 283 798
- US-A1- 2020 398 385
- US-B2- 6 672 373

## Beschreibung

### Stand der Technik

Die vorliegende Erfindung betrifft eine Kühlvorrichtung zum Kühlen von Bauteilen und eine Elektronikanordnung.

Üblicherweise führen Leistungshalbleiter in der Leistungselektronik hohe Ströme, welche zu einer hohen Verlustwärme führen können. Häufig ist eine Kühlung solcher Leistungshalbleiter erforderlich, beispielsweise zur Vermeidung von Schäden durch Überhitzen.

Zur Kühlung kann beispielsweise eine Flüssigkeitskühlung oder eine Luftkühlung verwendet werden. Weiterhin können zur Kühlung sogenannte Pulsating Heatpipe-Strukturen als Kühlvorrichtungen verwendet werden. Diese eignen sich besonders für die direkte Integration in bestehende Komponenten mit dem Ziel, effizient Wärme von thermischen Hotspots zu Wärmesenken abzuführen. Dabei wird die Wärme vom Ort der Wärmeeinbringung in der Regel zunächst mittels Wärmeleitung gespreizt. Eine als Pulsating Heatpipe ausgebildete Kühlvorrichtung umfasst einen Kühlkanal in der Kühlvorrichtung, welcher mäanderförmig ausgebildet ist und der mit einem Arbeitsmittel gefüllt ist, welches gleichzeitig gasförmig und flüssig in dem Kühlkanal vorliegt. In der Kühlvorrichtung wird in einem Grundbereich Wärme an den Kühlkanal übertragen, so dass das Arbeitsmittel in dem Kühlkanal lokal verdampft. Dabei entstehen Druckgradienten, die das Arbeitsmittel durch den Kühlkanal befördern.

Dabei wandern die Dampfblasen auch in einen Kondensatorteil des Kühlkanals und kondensieren dort. Die Wärme wird dadurch über die Wände des Kondensators und beispielsweise auch über Verrippungen an die Umgebung abgegeben. Insgesamt wird also die Wärme, die im Grundbereich in die Kühlvorrichtung eingebracht wird, auf die gesamte Kühlvorrichtung verteilt. Eine als Pulsating Heat Pipe ausgebildete Kühlvorrichtung dient somit als Wärmespreiz-Designelement. Entsprechende Pulsating Heat Pipe Kühlvorrichtungen werden z.B. in US 6 672 373 B2 und US 2020/398385 A1 diskutiert.

### Offenbarung der Erfindung

Erfindungsgemäß wird eine Kühlvorrichtung zum Kühlen von Bauteilen vorgeschlagen. Die Kühlvorrichtung umfasst einen Grundbereich, welcher wärmeleitend mit einem zu kühlenden Bauteil verbindbar ist, einen Umlenkbereich, einen Zwischenbereich zwischen dem Grundbereich und dem Umlenkbereich, und einen Kühlkanal, welcher mäanderförmig ausgebildet ist und mehrere Mittelsegmente und mehrere Umlenksegmente aufweist, wobei sich die Mittelsegmente jeweils von dem Grundbereich zum Umlenkbereich erstrecken, wobei die Umlenksegmente jeweils innerhalb des Grundbereichs und innerhalb des Umlenkbereichs eine Richtungsumkehr bilden und jeweils zwei Mittelsegmente miteinander verbinden, wobei der Kühlkanal mit einem Arbeitsmittel gefüllt ist, welches gleichzeitig gasförmig und flüssig in dem Kühlkanal vorliegt. Erfindungsgemäß weist eine Innenwand des Kühlkanals wenigstens eine gezielt lokal begrenzte Oberflächenstruktur mit einer erhöhten Rauigkeit auf, die mit dem Arbeitsmittel in Kontakt steht. Gemäß dem Stand der Technik weisen die Kühlkanäle über alle ihre Abschnittsbereiche hinweg eine gleich ausgeführte Oberfläche auf. Diese ist strukturell, insbesondere in Hinblick auf messbare Rauhigkeitswerte, geprägt durch das zur Ausbildung der Kühlkanäle entsprechend angewandte Herstellungsverfahren. Die Kühlkanäle werden beispielsweise durch Fräsen, Strangpressen oder Tiefziehen ausgebildet. Ohne besondere Vorkehrung weisen die den Kühlkanal ausbildenden Wandungsoberflächen eine quadratische Rauigkeit Rq (siehe EN ISO 4287) im Bereich von 0,2 µm - 0,5 µm auf. Je rauer die Oberfläche durch das Herstellungsverfahren ausfällt, umso größer ist der Strömungswiderstand für das Arbeitsmedium innerhalb des Kühlkanals. Insofern ist man normalerweise bestrebt, mit dem angewandten Herstellungsverfahren die Kühlkanäle zwar kostengünstig, aber auch mit einer möglichst glatten durchgängigen Oberfläche, d.h. mit niedrigen Rauigkeitswerten, auszubilden und damit auch den Strömungswiderstand klein zu halten.

### Vorteile der Erfindung

Gegenüber dem Stand der Technik weist die Kühlvorrichtung mit den Merkmalen des unabhängigen Anspruchs eine stark erhöhte Kühlwirkung auf. Bei einer Wärmezufuhr an den Grundbereich, das heißt, wenn sich das daran angrenzende Bauteil erwärmt, wird die Wärme von dem Grundbereich auf den Kühlkanal mit dem darin befindlichen Arbeitsmittel übertragen. Dadurch kann ein Phasenwechsel sowie eine Strömung des Arbeitsmittels innerhalb des Kühlkanals erzeugt werden, wodurch die Wärme von dem Grundbereich in Richtung Zwischenbereich transportiert wird. An einer Außenseite der Kühlvorrichtung, insbesondere in dem Zwischenbereich und dem Umlenkbereich, wird die Wärme durch Konvektion an die Umgebungsluft abgegeben. Dadurch kann ein, insbesondere unregelmäßiger, pulsierender oder oszillierender Phasenübergang des Arbeitsmittels erzeugt werden. Ebenso kann eine pulsierende oder oszillierende Strömung des Arbeitsmittels im Kühlkanal vorliegen. Die Kühlvorrichtung arbeitet somit nach dem Prinzip eines pulsierenden Wärmerohres, auch genannt Pulsating Heat Pipe.

Durch die gezielt lokal begrenzte Oberflächenstruktur mit erhöhter Rauigkeit an der Innenwand des Kühlkanals wird dieser über seinen gesamten Erstreckungsbereich über dann definierte Erstreckungsabschnitte hinweg mit unterschiedlichen Rauigkeitswerten bereitgestellt. So kann der Kühlkanal beispielsweise in bekannter Weise ausgebildet sein und durchgehend eine Wandungsoberfläche mit einer quadratischen Rauigkeit im Bereich von 0,2 µm - 0,5 µm aufweisen. Anschließend wird an definierten Erstreckungsabschnitten des Kühlkanals die Wandungsoberfläche lokal auf diese Abschnitte begrenzt gezielt aufgeraut, so dass hier die quadratische Rauigkeit bis in einen Wertebereich von 0,8 µm - 7 µm erhöht wird. An diesen Stelle der gezielt lokal begrenzten Oberflächenstruktur mit erhöhter quadratischen Rauigkeit Rq wird die Verdampfung des Arbeitsmittels vorteilhaft beeinflusst. An der besagten Oberflächenstruktur bilden sich in dem Arbeitsmittel zunächst Mikrodampfblasen, die sich ab einem gewissen Punkt ablösen bzw. von der Oberflächenstruktur in den Kühlkanal wachsen. Eine raue, beispielsweise poröse oder stark strukturierte, Oberflächenstruktur begünstigt die Verdampfung, da durch die Struktur eine im Bereich der Oberflächenstruktur vergrößerte Oberfläche für die Verdampfung zur Verfügung steht und somit geringere Oberflächenspannungen bei der Blasenbildung überwunden werden müssen. Dies führt zu einer kleineren erforderlichen Temperaturdifferenz zwischen der Innenwand des Kühlkanals und dem Arbeitsmittel. Dadurch wird bereits sehr früh zwischen der Innenwand des Kühlkanals und dem Arbeitsmittel die Verdampfung initialisiert und somit ein vorteilhaft verbesserter Wärmeübergang zwischen dem Kühlkanal und dem Arbeitsmittel herbeigeführt. Die lokal begrenzte Oberflächenstruktur mit erhöhter quadratischen Rauigkeit dient daher in der Funktion von vorteilhaften Keimzellen für eine frühzeitige Bildung von Verdampfungsblasen. Auch wenn die anderen Kühlkanalabschnitte weiterhin gemäß dem Stand der Technik möglichst glatte Oberflächen mit geringen Rauigkeitswerten aufweisen, wird im Mittel durch die gezielte lokal begrenzte Erhöhung der Rauigkeitswerte innerhalb definierter Kühlkanalabschnitte die Kühlleistung der Kühlvorrichtung gesteigert. In einem pulsierenden Wärmerohr kann somit durch die gezielt lokal begrenzte Oberflächenstruktur mit erhöhter quadratischen Rauigkeit an der Innenwand des Kühlkanals der Verdampfungsprozess des Arbeitsmittels in dem Kühlkanal optimiert werden. Zur nachträglichen lokal begrenzten Aufrauhung der Wandungsoberfläche innerhalb von definierten Kühlkanalabschnitten kann beispielsweise das ansonsten für andere Anwendungszwecke bekannte Glasperlenverfahren zum Einsatz kommen. Indem Glasperlen mit definierter Größe und mit definierter Geschwindigkeit auf die Oberflächenwandung auftreffen, werden kleinste mechanische Eindrücke und Eindellungen erzeugt, durch die die Oberflächenrauigkeit erhöht wird. Alternativ kann auch ein Sandstrahlen eingesetzt werden. Durch die eher undefinierte Formung der Sandkörner kann die Rauigkeit deutlich erhöht werden. Sowohl die Form als auch die Größe und die Geschwindigkeit der Partikel, welche auf die Wandungsoberfläche treffen, beeinflussen schlussendlich die ausbildbaren Rauigkeitswerte. Es hat sich als vorteilhaft gezeigt, dass eine quadratische Rauigkeit im Bereich von 2 µm - 5 µm ein gutes Verhältnis darstellt hinsichtlich der optimierten Leistungsfähigkeit der Kühlvorrichtung und den zur Herstellung erhöhter Rauigkeitswerten entstehenden Kosten. Es sind grundsätzlich auch andere Verfahren denkbar, die für eine lokal begrenzte Oberflächenaufrauhung in Frage kommen, beispielsweise ein Laserverfahrens, ein Ätzverfahren, ein mechanisches Aufrauen, beispielsweise mittels Bürsten. Auch kann beispielsweise beim Fräsen oder anderen Verfahren die abschnittsweise definierte Rauigkeit der Wandungsoberfläche während der Herstellung des Kühlkanals in einem Verfahrensschritt entsprechend variierend angepasst werden, indem beispielsweise Fertigungsparameter im definierten Kühlkanalabschnitt verändert werden.

Durch eine gezielte Auswahl, an welchen Stellen im Kühlkanal derartige lokal begrenzte Oberflächenstrukturen vorgesehen werden, kann die Funktionsweise des pulsierenden Wärmerohrs, der Pulsating Heat Pipe, gezielt beeinflusst und gesteuert werden. Durch die Kombination der Geometrie des Kühlkanals und der Auswahl der Stellen mit besagten lokal begrenzten Oberflächenstrukturen im Kühlkanal kann das Verhalten des Arbeitsmittels im Kühlkanal beeinflusst, das Strömungsregime in der Kühlvorrichtung gezielt verändert und somit der Wärmetransport in der Kühlvorrichtung verbessert werden. Vorteilhaft muss die gezielt lokal begrenzte Oberflächenstruktur mit erhöhter quadratischen Rauigkeit in einem Kühlkanalquerschnitt nicht durchgehend über die geschlossen umlaufende Kanalwandung ausgebildet sein. Bevorzugt ist die gezielt lokal begrenzte Oberflächenstruktur mit erhöhter quadratischen Rauigkeit daher nur auf einer Teilfläche der geschlossen umlaufenden Kanalwandung innerhalb eines Kühlkanalquerschnittes ausgebildet. Weiter bevorzugt ist diese Teilfläche innerhalb der Hälfte der geschlossen umlaufenden Kanalwandung angeordnet, welche der Entwärmungsseite der Kühlvorrichtung zugewandt ist. Die Teilfläche ist daher bevorzugt auf der Verdampferseite der Kühlvorrichtung angeordnet und umfasst insbesondere bis zur Hälfte der Fläche der geschlossen umlaufenden Kanalwandung innerhalb eines Kühlkanalquerschnittes. Der Vorteil begründet sich hier insbesondere durch den wirksamen Temperaturunterschied zwischen der Verdampferseite und der Kondensationsseite der Kühlvorrichtung, wobei erhöhte Rauigkeit auf Seite des Verdampfer für die frühzeitige Blasenbildung ausreicht. Zusätzlich verbleibt der Strömungswiderstand auf der Kondensationsseite gering, so dass sich insgesamt eine sehr gute Balance zwischen dem sich effektiv einstellenden Strömungswiderstand und der erreichbaren gesteigerten Kühlperformance einstellt.

Weitere vorteilhafte Ausgestaltungen und Weiterbildungen der Erfindungen werden durch die in den Unteransprüchen angegebenen Merkmale ermöglicht.

Gemäß einem vorteilhaften Ausführungsbeispiel ist vorgesehen, dass die genannte lokal begrenzte Oberflächenstruktur der Innenwand des Kühlkanals in wenigstens einem Umlenksegment im Grundbereich der Kühlvorrichtung ausgebildet ist. Der Grundbereich dient der Aufnahme von Wärme aus dem Bauteil und als Verdampfer für das Arbeitsmittel, das im Kühlkanal angeordnet ist. Eine im Grundbereich der Kühlvorrichtung, der als Verdampferteil wirkt, ausgebildete gezielt lokal begrenzte Oberflächenstruktur mit erhöhter quadratischen Rauigkeit führt zu einer an dieser Oberflächenstruktur verbesserten Verdampfung und somit zu einer im Grundbereich verbesserten Verdampfung. Dadurch, dass die lokale Oberflächenstruktur lokal im Grundbereich ausgebildet ist, wird der Strömungswiderstand in dem Kühlkanal nur an diesen Stellen und somit insgesamt nur unwesentlich negativ beeinflusst, während die Verdampfung des Arbeitsmittels deutlich begünstigt wird. Der verdampfungsseitige Wärmeübergang zwischen dem Kühlkanal und dem Arbeitsmittel, der vor allem bei der Entwärmung von Bauteilen mit hoher Wärmestromdichte der Flaschenhals für die thermische Performance der Kühlvorrichtung sein kann, wird durch die gezielt lokal begrenzte Oberflächenstruktur mit erhöhter quadratischen Rauigkeit somit verbessert und die Ableitung der Wärme von dem Bauteil durch die Kühlvorrichtung verbessert. Da die Wärme vom Bauteil durch den Grundbereich und die in dem Grundbereich angeordneten Umlenksegmente aufgenommen wird und an die Arbeitsflüssigkeit in dem Kühlkanal abgegeben wird, kann durch die in den Umlenksegmenten ausgebildete besagte Oberflächenstruktur die Verdampfung verbessert werden, so dass die Wärme aus dem Bauteil direkt in den Umlenksegmenten eine Verdampfung der Arbeitsflüssigkeit bewirkt.

Gemäß einem vorteilhaften Ausführungsbeispiel ist vorgesehen, dass die lokal begrenzte Oberflächenstruktur mit erhöhter quadratischen Rauigheit einseitig in dem Umlenksegment im Grundbereich ausgebildet ist. Dies bedeutet, dass von zwei an das Umlenksegment angrenzenden Kühlkanalabschnitte, lediglich auf der Seite eines dieser Kühlkanalabschnitte die lokal begrenzte Oberflächenstruktur mit erhöhter quadratischen Rauigkeit ausgebildet ist. Vorteilhaft können auf diese Weise in eine Richtung gleichgerichtete Druckgradienten entstehen, die dafür sorgen, dass die Strömung der Arbeitsflüssigkeit in eine Vorzugsrichtung erfolgt. Statt oszillierenden Bewegungen des Arbeitsmittels mit häufigen Richtungswechseln, wie es normalerweise in als Pulsating Heat Pipes ausgebildeten Kühlkörpern auftreten kann, strömt das Arbeitsmittel vorzugsweise umlaufend durch den Kühlkanal. So kann vorteilhaft das globale Strömungsregime von einer ausschließlich pulsierenden in eine zirkulierend-pulsierende Strömung des Arbeitsmittels überführt werden. Ein derart erzeugte zirkulierend-pulsierende Strömung ist eine von einer Zirkulation überlagerte pulsierende Bewegung, die eine stark erhöhte, thermische Performance aufweist. Dazu wird die Tatsache genutzt, dass die sich im Kühlkanal bildenden Blasen nach ihrer Entstehung an der lokal begrenzten Oberflächenstruktur vorzugsweise in die geraden Mittelsegmente des Kühlkanals wandern, statt den Umlenkabschnitt im Grundbereich zu passieren. Ist nun im Grundbereich in dem Umlenkabschnitten jeweils nur eine Seite des Umlenkabschnitts mit einer gezielt lokal begrenzten Oberflächenstruktur mit erhöhter quadratischen Rauigkeit versehen, während die andere Seite desselben Umlenkabschnitts keine solche gezielt lokal begrenzte Oberflächenstruktur mit erhöhter quadratischen Rauigkeit aufweist, sondern glatt ist, entstehen immer auf der Seite mit der gezielt lokal begrenzten Oberflächenstruktur bevorzugt Blasen. Da diese Blasen dann immer auf der Seite ihrer Entstehung in das gerade Mittelsegment der Kühlkanals weiterströmen, ergibt sich an jedem Umlenkabschnitt im Grundbereich eine Vorzugsrichtung der Strömung. Über die gesamte Kühlvorrichtung betrachtet entsteht so eine überlagerte zirkulierende Bewegung, die den Wärmeübergang erheblich verbessert.

Gemäß einem vorteilhaften Ausführungsbeispiel ist vorgesehen, dass die Umlenksegmente in dem Grundbereich in einer Reihe nebeneinander ausgebildet sind, wobei die gezielt lokal begrenzte Oberflächenstruktur mit erhöhter quadratischen Rauigkeit in wenigstens einem in der Reihe außen liegenden Umlenksegmente ausgebildet ist, wobei wenigstens ein in der Reihe innen liegendes Umlenksegment keine derartige lokal begrenzte Oberflächenstruktur aufweist. Abhängig von der Geometrie, Orientierung zur Schwerkraft und dem Leistungsbereich der Kühlvorrichtung mit der Pulsating Heat Pipe sind nicht immer alle Bereiche des Kühlkanals im gleichen Strömungsregime bzw. nicht alle Kanäle aktiv. Beispielsweise kann bei engen Kanalkrümmungen an den Umlenksegmenten, einer vertikalen Orientierung zur Schwerkraft und Beheizung von unten, sowie einem niedrigen Leistungsbereich, vor allem bei großem Füllstand des Kühlkanals mit Arbeitsmittel eine Inaktivierung der äußeren Bereiche des Kühlkanals auftreten. Dies kann zum einen daran liegen, dass bei gleichmäßiger Beheizung die Temperatur an den inneren Bereichen des Kühlkanals im Grundbereich am größten ist und zu den Seiten hin abfällt. Zum anderen führt der global geringe Wärmestrom zu einer niedrigen Blasenentstehungsrate, die für die Kinetik des Fluids entscheidend ist. Außerdem sorgen die hohen Druckgradienten in den engen Umlenksegmenten dafür, dass Blasen nach ihrer Entstehung vorzugsweise in die geraden Mittelsegmente des Kühlkanals wandern, statt zuerst durch das Umlenksegment und dann in das benachbarte Mittelsegment zu wandern. So kann es passieren, dass zwar die mittleren Bereiche des Kühlkanals pulsieren, jedoch die äußeren Bereiche kaum oder nicht wie gewünscht pulsieren. Diesem Effekt wird vorteilhaft entgegengewirkt, indem in äußeren Umlenksegmenten im Grundbereich gezielt lokal begrenzte Oberflächenstrukturen mit erhöhter quadratischen Rauigkeit vorgesehen werden. Durch derartige Oberflächenstrukturen erhöht sich in den äußeren Umlenksegmenten die Blasenentstehungsrate und die außenliegenden Bereiche des Kühlkanals werden kinetisch aktiviert. Dies führt in der Kühlvorrichtung zu einem global verbesserten Wärmeübergang. Bevorzugt ist die Kühlvorrichtung in Form einer Pulsating Heat Pipe auf seiner Verdampfungsseite mit einem zu entwärmenden elektrischen und/oder elektronischen Bauelement zumindest thermisch verbunden, bevorzugt einem Leistungshalbleiter oder einem Chip. Dabei weisen gerade die äußeren Umlenksegmente, die in einer senkrechten Draufsicht auf die Verdampferseite nicht von der Entwärmungsfläche des elektrischen und/oder elektronischen Bauelementes überdeckt sind, die gezielt lokal begrenzte Oberflächenstruktur mit erhöhter quadratischen Rauigkeit auf. Damit können hier die ansonsten im Mittel flüssig vorliegenden Anteile des Arbeitsmittels kompensiert werde durch eine erleichterte Blasenbildung. Dagegen weisen alle anderen Kühlkanalabschnitte, die von der Entwärmungsfläche des elektrischen und/oder elektronischen Bauelementes überdeckt sind und damit sich im Hotspotbereich befinden, keine derartigen Oberflächenstrukturen auf. Allgemein denkbar ist es, die gezielt lokal begrenzten Oberflächenstrukturen mit zunehmend erhöhten Rauigkeitswerten auszubilden, je weiter sie von einem Hot Spot entfernt sind.

Gemäß einem vorteilhaften Ausführungsbeispiel ist vorgesehen, dass in beiden äußeren Umlenksegmenten im Grundbereich jeweils eine gezielt lokal begrenzte Oberflächenstruktur mit erhöhter quadratischen Rauigkeit ausgebildet ist, wobei die in der Reihe innen liegenden Umlenksegmente keine derartigen lokal begrenzte Oberflächenstruktur aufweisen.

Gemäß einem vorteilhaften Ausführungsbeispiel ist vorgesehen, dass in wenigstens einem Mittelsegmenten wenigstens eine gezielt lokal begrenzte Oberflächenstruktur mit erhöhter quadratischen Rauigkeit ausgebildet ist. So kann das Startverhalten und der thermische Widerstand der Kühlvorrichtung auch in nicht bevorzugten Orientierungen der Kühlvorrichtung optimiert werden. Unter nicht bevorzugter Richtung wir eine Orientierung der Kühlvorrichtung im Raum verstanden, bei der sich der Grundbereich der Kühlvorrichtung von dem die Wärme des zu kühlenden Bauteils aufgenommen wird, nicht unten befindet. Der Grundbereich der Kühlvorrichtung ist im Raum nicht nach unten orientiert, sondern nach oben oder zur Seite. Wird der Grundbereich der Kühlvorrichtung im Raum nach oben ausgerichtet und die Kühlvorrichtung somit von oben beheizt, gibt es in der Kühlvorrichtung keinen Wärmestrom, der Wärmestrom ist im Stillstand, im sogenannten Dryout. Das bedeutet, dass sich im Grundbereich nur noch Dampf befindet und sich die gesamte Flüssigkeit Umlenkbereich oder im Zwischenbereich sammelt. Derselbe Effekt kann bei horizontaler Orientierung bereits bei sehr kleinen Leistungen auftreten. Dies kann zum Ausfall der Funktion der Kühlvorrichtung als Pulsating Heat Pipe führen. Durch gezielt lokal begrenzte Oberflächenstrukturen mit erhöhter quadratischen Rauigkeit in den Mittelsegmenten kann dem Stillstand des Wärmestroms entgegengewirkt werden. Im Dryout sammelt sich an diesen Stellen bei ausreichendem Füllstand bereits Flüssigphase. Wird nun Wärme in den Grundbereich eingebracht, wird diese über Wärmeleitung über den Zwischenbereich in Richtung Umlenkbereich transportiert. Erreicht der Wärmestrom die besagte lokal begrenztet Oberflächenstruktur, führt dies schnell zur Blasenbildung und zu einem Start der Funktionsweise der Kühlvorrichtung als Pulsating Heat Pipe. Dabei wird wieder Flüssigphase in den Grundbereich transportiert, sodass erneut ein guter Wärmeübergang erreicht werden kann. Bei noch nicht angelaufener Pulsating Heat Pipe ist die gezielt lokal begrenzte Oberflächenstruktur mit erhöhter quadratischen Rauigkeit in den Bereich der Oberkante des Flüssigkeitsstands des Arbeitsmittels angeordnet.

Gemäß einem vorteilhaften Ausführungsbeispiel ist vorgesehen, dass in allen Mittelsegmenten wenigstens eine derart lokal begrenzte Oberflächenstruktur ausgebildet ist.

Gemäß einem vorteilhaften Ausführungsbeispiel ist vorgesehen, dass die Innenwand des Kühlkanals im Bereich der gezielt lokalen Oberflächenstruktur eine lokal erhöhte Rauheit aufweist. Eine lokale Oberflächenstruktur mit erhöhter Rauheit begünstigt vorteilhaft lokal die Verdampfung des Arbeitsmittels in dem Kühlkanal. Der Kühlkanal weist an der lokalen Oberflächenstruktur eine Rauheit auf, die gegenüber dem die lokale Oberflächenstruktur umgebenden Bereich des Kühlkanals erhöht ist.

Gemäß einem vorteilhaften Ausführungsbeispiel ist vorgesehen, dass die Innenwand des Kühlkanals im Bereich der gezielt lokal begrenzten Oberflächenstruktur eine höhere Rauheit aufweist als die Innenwand des Kühlkanals an den Umlenksegmenten in dem Umlenkbereich. So kann die Verdampfung des Arbeitsmittels an der gezielt lokal begrenzten Oberflächenstruktur erhöht werden und gleichzeitig an den Umlenksegmenten im Umlenkbereich ein geringer Strömungswiderstand erzielt werden, der einen ungestörten Fluss des Arbeitsmittels durch den Kühlkanal im Umlenkbereich ermöglicht.

Weiterhin führt die Erfindung zu einer Elektronikanordnung, welche die beschriebene Kühlvorrichtung umfasst. Ferner umfasst die Elektronikanordnung ein zu kühlendes Bauteil, welches insbesondere ein Halbleiterbauteil, beispielsweise eines Kraftfahrzeugs, ist. Das zu kühlende Bauteil ist mit einem Grundbereich der Kühlvorrichtung wärmeleitend verbunden. Die Kühlvorrichtung ermöglicht dabei eine besonders effektive und zuverlässige Kühlung des Bauteils, um eine Überhitzung zu vermeiden.

### Kurze Beschreibung der Zeichnungen

Ein Ausführungsbeispiel der Erfindung ist in der Zeichnung dargestellt und wird in der nachfolgenden Beschreibung näher erläutert. Es zeigt
- Fig. 1: eine schematische Darstellung eines ersten Ausführungsbeispiels der Kühlvorrichtung,
- Fig. 2: eine schematische Darstellung eines zweiten Ausführungsbeispiels der Kühlvorrichtung,
- Fig. 3: eine schematische Darstellung eines dritten Ausführungsbeispiels der Kühlvorrichtung.

### Ausführungsformen der Erfindung

Die Figuren zeigen schematische Darstellungen von Ausführungsbeispielen einer Elektronikanordnung 100 mit einer Kühlvorrichtung 1. Die Kühlvorrichtung 1 kann zur Kühlung von Elektronik oder anderen Hotspots aller Art, beispielsweise zur Kühlung von Leistungselektronik in E-Fahrzeugen, passiver Batteriekühlung, Kühlung von Motorsteuergeräten, Ladestationen oder Drive-Units in eBikes verwendet werden. Die Kühlvorrichtungen 1 der drei verschiedenen Ausführungsbeispiele in den drei verschiedenen Figuren unterscheiden sich darin, an welchen Stellen im Kühlkanal 5 gezielt lokal begrenzte Oberflächenstrukturen 54 mit erhöhter quadratischen Rauigkeit vorgesehen sind.

Die Elektronikanordnung 100 umfasst ein Bauteil 101, beispielsweise mit einer Leistungselektronik, beispielsweise ein Halbleiterbauteil, und eine Kühlvorrichtung 1. Die Kühlvorrichtung 1 ist dabei ausgebildet das Bauteil 101 zu kühlen. Hierfür ist ein Grundbereich 2 der Kühlvorrichtung 1 wärmeleitend mit dem Bauteil 101 verbunden. Das Bauteil 101 liegt dazu beispielsweise mittelbar oder unmittelbar auf dem Grundbereich 2 der Kühlvorrichtung 1auf.

Die Kühlvorrichtung 1 umfasst einen Kühlkanal 5, welcher mehrere Mittelsegmente 51 sowie mehrere Umlenksegmente 52 aufweist. Der Kühlkanal 5 verläuft in der Kühlvorrichtung 1. Der Kühlkanal 5 ist mäanderförmig ausgebildet. Als mäanderförmig wird dabei insbesondere eine Form angesehen, welche mehrere Richtungswechsel, vorzugsweise in einer Ebene, aufweist. Beispielsweise kann mäanderförmig auch als schlangenförmig bezeichnet werden. Der Kühlkanal 5 kann dabei als mäanderförmig gebogenes Rohr ausgebildet sein. Der Kühlkanal 5 kann beispielsweise einen kreisförmigen, einen elliptischen oder einen rechteckförmigen Querschnitt aufweisen. Der Kühlkanal 5 kann beispielsweise einen Durchmesser von etwa 0,5 bis 2 mm aufweisen.

Der Kühlkanal 5 kann beispielsweise in einem einstückigen gebogenen Rohr ausgebildet sein. Der Kühlkanal 5 kann aber auch in einer mehrteiligen Kühlvorrichtung 1 ausgebildet sein, die beispielsweise aus mehreren Rohrsegmenten und/oder Platten oder anderen Bauteilen zusammengesetzt sein kann. Der Kühlkanal 5 kann beispielsweise zumindest teilweise in einer oder mehreren massiven Platten, beispielsweise im Umlenkbereich 3 und/oder im Zwischenbereich 4 und/oder im Grundbereich 2, verlaufen. In den massiven Platten können beispielsweise Ausfräsungen vorgesehen sein, die den Kühlkanal 5 oder Teile des Kühlkanals 5 bilden. Der Kühlkanal 5 kann beispielsweise auch zwischen Blechen, die zu einer Kühlvorrichtung 1 gestapelt und miteinander verschweißt oder verlötet sind, verlaufen.

Der Kühlkanal 5 ist vorzugsweise rohrförmig ausgebildet. Bevorzugt ist der Kühlkanal 5 geschlossen ausgebildet. Hierfür weist der Kühlkanal 5 vorzugsweise einen Verbindungsbereich 58 auf, welcher sich vorzugsweise innerhalb des Umlenkbereichs 3 befindet, und welcher einen geschlossenen Kreislauf des Kühlkanals 5 bildet. Weiter bevorzugt weist der Kühlkanal 5 ein Ventil auf, um beispielsweise eine Evakuierung des Kühlkanals 5 und eine Befüllung des Kühlkanals 5 mit dem Arbeitsmittel 6 zu ermöglichen.

Wie in den Figuren dargestellt, erstreckt sich der Kühlkanal 5 von dem Grundbereich 2 durch einen Zwischenbereich 4 bis hin zu einem Umlenkbereich 3. Die Mittelsegmente 51 erstrecken sich jeweils von dem Grundbereich 2 zum Umlenkbereich 3, also durch den Zwischenbereich 4 hindurch. Dabei sind alle Mittelsegmente 51 gerade ausgebildet und parallel zueinander angeordnet. Die Umlenksegmente 52 sind jeweils an den Enden der Mittelsegmente 51 im Umlenkbereichs 3 sowie im Grundbereich 2 angeordnet und bilden jeweils eine Richtungsumkehr. Dabei verbindet jeweils ein Umlenksegment 52 zwei Mittelsegmente 51 miteinander.

Die Umlenksegmente 52 sind beispielsweise jeweils U-förmig ausgebildet und weisen einen Biegeradius auf. Dadurch sind die Mittelsegmente 51 in einem Abstand, welcher dem doppelten Biegeradius 55 entspricht, zueinander angeordnet. Grundbereichsseitig verlaufen die Umlenksegmente 52 beispielsweise in einer Grundplatte, die einen flächigen Kontakt zu dem Bauteil 101 bilden kann. Die Grundplatte weist beispielsweise eine hohe Wärmeleitfähigkeit auf und ist beispielsweise aus Aluminium ausgebildet, um eine gute Wärmeleitung und thermische Anbindung des Bauteils 101 und einen effektiven Wärmeabtransport von dem Bauteil 101 zu ermöglichen. Weiter bevorzugt ist die Kühlvorrichtung 1 insgesamt aus Aluminium gebildet, um kostengünstig und thermisch gut leitend zu sein.

Innerhalb des Kühlkanals 5 befindet sich ein Arbeitsmittel 6, welches gleichzeitig in flüssigen und in gasförmigen Zustand vorliegt. Das Arbeitsmittel 6 liegt in dem Kühlkanal 5 gleichzeitig gasförmig und flüssig vor, mit anderen Worten teils gasförmig und teils flüssig. Das heißt, das Arbeitsmittel 6 liegt im Kühlkanal 5 zweiphasig vor. Insbesondere liegen dabei innerhalb des Kühlkanals 5 Gasblasen sowie Flüssigkeitssäulen gleichzeitig vor. Vorzugsweise nehmen bei einer Nenntemperatur die Gasblasen sowie die Flüssigkeitssäulen ein ähnlich großes Volumen ein. Besonders bevorzugt nimmt der gasförmige Anteil des Arbeitsmittels 6 bei der Nenntemperatur 30 % bis 70 % eines Innenvolumens des Kühlkanals 5 ein, wobei das restliche Innenvolumen durch den flüssigen Anteil des Arbeitsmittels 6 eingenommen wird. In Abhängigkeit einer Temperatur der Kühlvorrichtung 1 ändert sich dabei das Volumenverhältnis durch Verdampfen oder Kondensieren des Arbeitsmittels 6.

Bei einer Erwärmung des Grundbereichs 2 der Kühlvorrichtung 1 durch das Bauteil 101 erfolgt eine Erwärmung des Kühlkanals 5 sowie des darin befindlichen Arbeitsmittels. Durch eine Kombination aus Verdampfung, Kondensation, konvektivem Wärmetransport und Wärmeleitung erfolgt ein Abtransport der Wärme vom Grundbereich 2 und somit eine Kühlung des Bauteils 101. Besonders bevorzugt weist das Arbeitsmittel 6 eine kritische Temperatur auf, die größer als eine maximale Betriebstemperatur ist. Vorzugsweise weist das Arbeitsmittel 6 eine kritische Temperatur von mindestens 233 K, vorzugsweise mindestens 273 K besonders vorzugsweise mindestens 373 K, und insbesondere maximal 533 K, auf. Als kritische Temperatur wird dabei eine Temperatur eines Stoffes am kritischen Punkt angesehen. Dadurch wird sichergestellt, dass das Arbeitsmittel 6 in einem bevorzugten Betriebsbereich, in welchem das Arbeitsmittel 6 insbesondere bei Temperaturen von 222 K bis 473k, insbesondere von 273 K bis 373 K, vorliegt, zweiphasig innerhalb des Kühlkanals 5 vorliegen kann. Vorzugsweise ist das Arbeitsmittel 6 ein organisches Kältemittel, welches beispielsweise in Fahrzeugklimaanlagen eingesetzt wird, wie insbesondere 2,3,3,3-Tetrafluorpropen, auch als R1234yf bezeichnet, R1233zd(E) usw. Besonders bevorzugt weist das Arbeitsmittel 6 einen Schmelzpunkt auf, welcher maximal 273 K, vorzugsweise maximal 233K, besonders bevorzugt maximal 213 K, beträgt.

Der Kühlkanal 5 verläuft als Kanal durch die Kühlvorrichtung 1. Der Kühlkanal 5 weist eine Innenwand 53 auf. Die Innenwand 53 ist die Seite des Kühlkanals 5, die mit dem Arbeitsmittel 6 in direktem Kontakt steht. An der Innenwand 53 des Kühlkanals 5 sind gezielt und lokal begrenzt eine oder mehrere Oberflächenstrukturen 54 mit einer erhöhten quadratischen Rauigkeit ausgebildet im Vergleich zu daran angrenzenden Kühlkanalabschnitten, die im Wesentlichen eine gleiche Rauigkeit aufweisen, insbesondere aufgrund eines gleich angewandten Fertigungsverfahrens, welches bei der Herstellung des Kühlkanals in diesen Kühlkanalabschnitten die Oberfläche maßgeblich geprägt hat. An der gezielt lokal begrenzten Oberflächenstruktur 54 ist die Innenwand 53 des Kühlkanals 5 beispielsweise strukturiert, insbesondere stärker aufgeraut. An der gezielt lokal begrenzten Oberflächenstruktur 54 ist die Innenwand 53 des Kühlkanals 5 beispielsweise daher nicht glatt ausgebildet. Die Innenwand 53 weist an der gezielt lokal begrenzten Oberflächenstruktur 54 beispielsweise eine Vielzahl an Erhöhungen und/oder Vertiefungen auf, wobei die Erhöhungen und/oder Vertiefungen die besagte Oberflächenstruktur 54 bilden. Die Oberflächenstruktur 54 ist lokal begrenzt, das heißt die Oberflächenstruktur 54 ist nur an einem begrenzten Teil und/oder entlang eines begrenzten Längenabschnitts der Innenwand 53 des Kühlkanals 5 ausgebildet. Andere Teile der Innenwand 53 des Kühlkanals 5 weisen entsprechend keine derartige gezielt lokal begrenzte Oberflächenstruktur 54 mit erhöhter quadratischen Rauigkeit auf, sondern sind glatt ausgebildet. Die besagte lokal begrenzte Oberflächenstruktur 54 an der Innenwand 53 des Kühlkanals 5 steht mit dem Arbeitsmittel 6 in direktem Kontakt. So kann Wärme von der gezielt lokal begrenzten Oberflächenstruktur 54 direkt an das Arbeitsmittel 6 abgeben werden. Die Innenwand 53 des Kühlkanals 5 kann an der Oberflächenstruktur 54 beispielsweise eine lokal erhöhte Rauheit aufweisen. Die lokal begrenzte Oberflächenstruktur 54 an der Innenwand 5 des Kühlkanals 5 kann beispielsweise durch Sandstrahlen, Glasperlenstrahlen, Ätzen oder Fräsen erzeugt sein. Dabei wird die Innenwand 5 des Kühlkanals 5, die vorher beispielsweise eine glatte Oberfläche aufwies, durch Sandstrahlen, Ätzen oder Fräsen behandelt und so in dem Bereich, in dem die Innenwand 5 des Kühlkanals 5 derart behandelt wurde, die lokal begrenzte Oberflächenstruktur 54 mit erhöhter quadratischen Rauigkeit erzeugt. Die Innenwand 53 des Kühlkanals 5 ist durch die Behandlung beispielsweise aufgeraut oder in anderer Weise strukturiert und weist somit eine lokal begrenzte derartige Oberflächenstruktur auf. Weiterhin kann die Kühlvorrichtung 1 oder zumindest Teile der Kühlvorrichtung 1 mittels eines 3D-Druckverfahrens hergestellt sein. So kann der Kühlkanal 5 in der Kühlvorrichtung 1 teilweise glatt und teilweise mit besagter lokal begrenzten Oberflächenstrukturen 54 ausgebildet werden.

An der Innenwand 53 des Kühlkanals 5 können eine oder mehrere lokal begrenzte Oberflächenstrukturen 54 mit erhöhter quadratischen Rauigkeit ausgebildet sein. Die in den Figuren dargestellten Ausführungsbeispiele unterscheiden sich darin, an welchen Stellen die derartigen lokal begrenzten Oberflächenstrukturen im Kühlkanal 5 vorgesehen sind. Die Richtung g stellt in den Figuren die Richtung der Schwerkraft dar. Die Figuren zeigen jeweils die bevorzugte Ausrichtung des jeweilen Ausführungsbeispiels der Kühlvorrichtung 1 bezüglich der Richtung g der Schwerkraft.

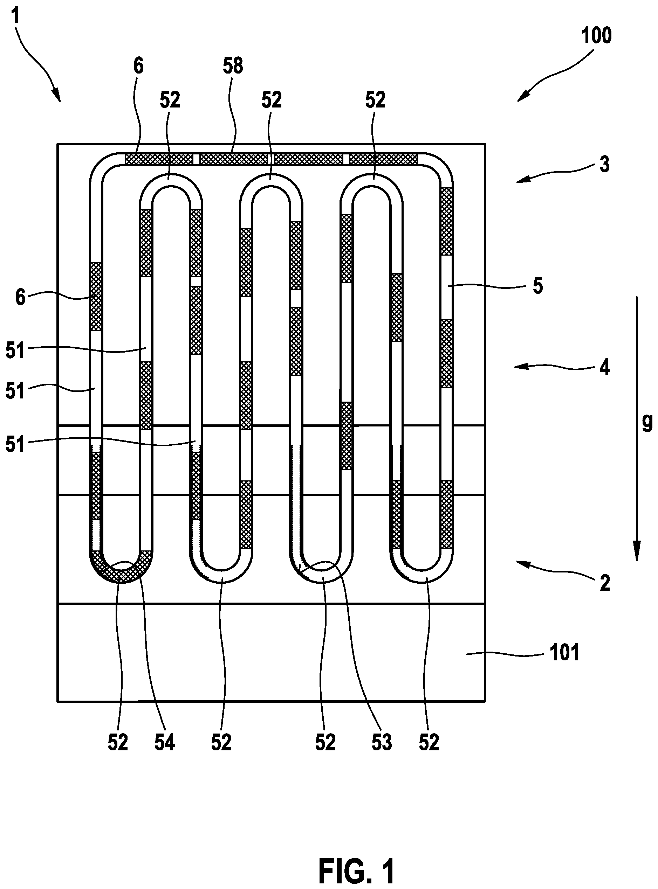

In dem in Fig. 1 dargestellten ersten Ausführungsbeispiel sind die lokal begrenzten Oberflächenstrukturen 54 mit erhöhter quadratischen Rauigkeit in dem Grundbereich 2 ausgebildet. Der Kühlkanal 5 weist in jedem der Umlenksegmente 52 im Grundbereich 2 der Kühlvorrichtung 1 eine jeweils besagte lokal begrenzte Oberflächenstruktur 54 auf. Diese lokal begrenzten Oberflächenstrukturen 54 sind in den Umlenksegmenten 52 jeweils einseitig ausgebildet. Die Umlenksegmente 52 im Grundbereich 2 der Kühlvorrichtung 1 sind U-förmig ausgebildet. Eine Seite der U-förmigen Biegung weist eine lokal begrenzte Oberflächenstruktur 54 mit erhöhter quadratischen Rauigkeit auf, wobei die andere Seite der U-förmigen Biegung des Umlenksegments 52 keine derartige lokal begrenzte Oberflächenstruktur 54 aufweist, also beispielsweise glatt ausgebildet ist. Vorzugsweise weisen, wie in dem in Fig. 1 dargestellten Ausführungsbeispiel, alle Umlenksegmente 52 eine auf einer Seite des Umlenksegments 52 ausgebildete besagte gezielt lokal begrenzte Oberflächenstruktur 54 auf, wobei die Oberflächenstrukturen 54 vorzugsweise an allen Umlenksegmenten 52 an der gleichen Seite der Umlenksegmente 52 ausgebildet sind. Die Wärme des Bauteils 101 wird vom Grundbereich 2 aufgenommen und an das Arbeitsmittel 6, das in dem Teil des Kühlkanals 5, der im Grundbereich 2 angeordnet ist, abgegeben. Die sich im Kühlkanal 5 an den genannten lokal begrenzten Oberflächenstrukturen 54 bildenden Blasen, wandern nun von vorzugsweise in die geraden Mittelsegmente 51 auf der Seite des Umlenksegments 52, das die lokal begrenzte Oberflächenstruktur 54 aufweist. Somit ergibt sich an jedem Umlenksegment 52 im Grundbereich 2 eine Vorzugsrichtung der Strömung. Über die gesamte Kühlvorrichtung 1 betrachtet entsteht so eine überlagerte zirkulierende Bewegung.

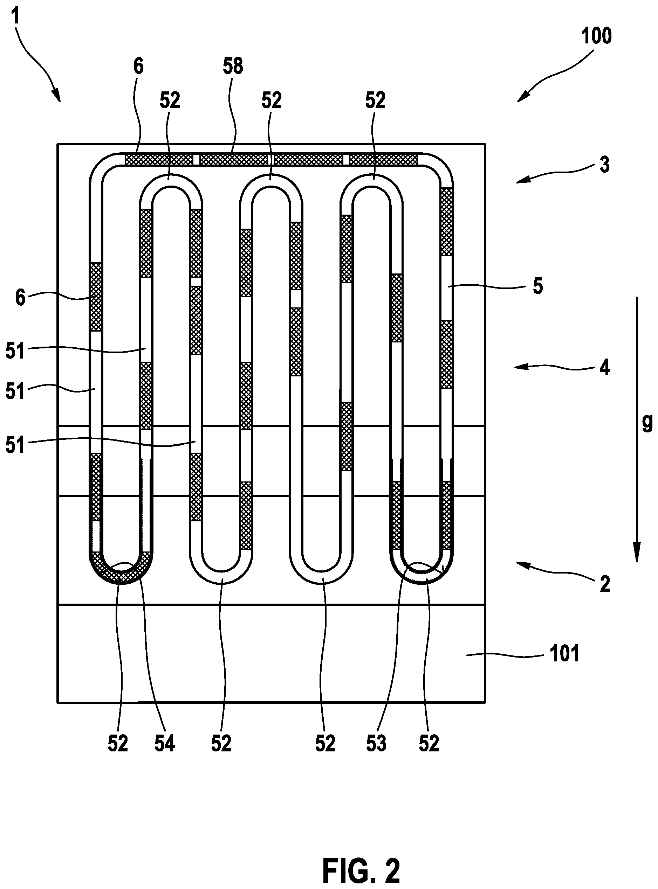

In dem in Fig. 2 dargestellten zweiten Ausführungsbeispiel der Kühlvorrichtung 1 sind die gezielt lokal begrenzten Oberflächenstrukturen 54 mit erhöhter quadratischen Rauigkeit in dem Grundbereich 2 der Kühlvorrichtung 1 angeordnet. Die Umlenksegmente 52 sind in dem Grundbereich 2 in einer Reihe nebeneinander ausgebildet. Die genannten lokal begrenzten Oberflächenstrukturen 54 sind in den in der Reihe der Umlenksegmente 52 außen liegenden Umlenksegmenten 52 ausgebildet. In diesem Ausführungsbeispiel weisen die zwei äußersten Umlenksegmente 52 jeweils eine derartige lokal begrenzte Oberflächenstruktur 54 auf. Die übrigen im Grundbereich 2 angeordneten Umlenksegmente 52 weisen keine derartige lokal begrenzte Oberflächenstruktur 54 auf, sondern weisen eine glatte Oberfläche auf.

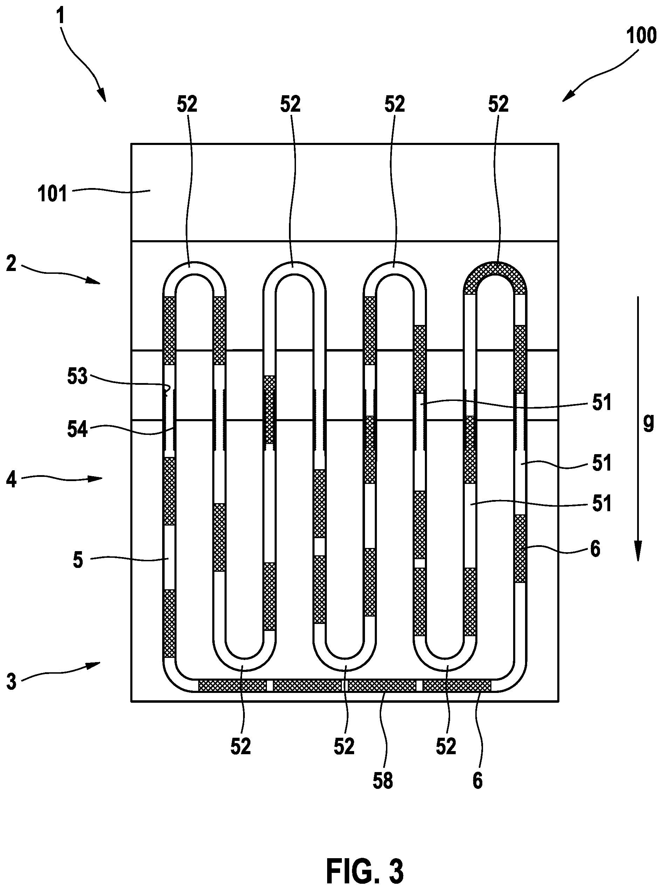

In dem in Fig. 3 dargestellten Ausführungsbeispiel sind die gezielt lokal begrenzten Oberflächenstrukturen 54 mit erhöhter quadratischen Rauigkeit in den Mittelsegmenten 51 des Kühlkanals 5 ausgebildet. So kann die Kühlvorrichtung 1 vorteilhaft auch in nicht bevorzugten Orientierungen, wie in Fig. 3 dargestellt, optimiert werden. Der Grundbereich 2 kann dabei, bezüglich der Richtung der Schwerkraft g, auch oberhalb des Umlenkbereichs 3 der Kühlvorrichtung 1 angeordnet sein. Ist die Kühlvorrichtung 1 derart angeordnet, sammelt sich die flüssige Phase des Arbeitsmittels 6 bevorzugt im Umlenkbereich 3 der Kühlvorrichtung. Wird nun Wärme in den Grundbereich 2 eingebracht, wird diese über Wärmeleitung über den Zwischenbereich 4 in Richtung Umlenkbereich 3 transportiert. Erreicht der Wärmestrom die besagten lokal begrenzten Oberflächenstrukturen 54 in den Mittelsegmenten 51 des Kühlkanals, so entstehen im Bereich der lokal begrenzten Oberflächenstrukturen 54 in den Mittelsegmenten 51 des Kühlkanals 5 Blasen im Kühlkanal 5. So kann durch die in den Mittelsegmenten 51 ausgebildeten derartigen Oberflächenstrukturen 54 die Kühlvorrichtung 1 trotz ungünstiger Ausrichtung als Pulsating Heat Pipe funktionieren.

## Patentansprüche

1. Kühlvorrichtung, zum Kühlen von Bauteilen (101) umfassend:
- einen Grundbereich (2), welcher wärmeleitend mit einem zu kühlenden Bauteil (101) verbindbar ist,
- einen Umlenkbereich (3),
- einen Zwischenbereich (4) zwischen dem Grundbereich (2) und dem Umlenkbereich (3), und
- einen Kühlkanal (5), welcher mäanderförmig ausgebildet ist und mehrere Mittelsegmente (51) und mehrere Umlenksegmente (52) aufweist,
- wobei sich die Mittelsegmente (51) jeweils von dem Grundbereich (2) zum Umlenkbereich (3) erstrecken,
- wobei die Umlenksegmente (52) jeweils innerhalb des Grundbereichs (2) und innerhalb des Umlenkbereichs (3) eine Richtungsumkehr bilden und jeweils zwei Mittelsegmente (51) miteinander verbinden,
- wobei der Kühlkanal (5) mit einem Arbeitsmittel (6) gefüllt ist, welches gleichzeitig gasförmig und flüssig in dem Kühlkanal (5) vorliegt,
**dadurch gekennzeichnet, dass**
eine Innenwand (53) des Kühlkanals (5) wenigstens eine lokal begrenzte Oberflächenstruktur (54) aufweist, die mit dem Arbeitsmittel (6) in Kontakt steht, wobei die lokal begrenzte Oberflächenstruktur (54) einseitig in dem Umlenksegment (52) im Grundbereich (2) ausgebildet ist unter Ausbildung einer zirkulierend-pulsierenden Strömung des Arbeitsmittels (6) in eine Vorzugsrichtung.

2. Kühlvorrichtung nach Anspruch 1, **dadurch gekennzeichnet, dass** in wenigstens einem Mittelsegmenten (51) wenigstens eine lokal begrenzte Oberflächenstruktur (54) ausgebildet ist.

3. Kühlvorrichtung nach Anspruch 2, **dadurch gekennzeichnet, dass** in allen Mittelsegmenten (51) wenigstens eine lokal begrenzte Oberflächenstruktur (54) ausgebildet ist.

4. Kühlvorrichtung nach einem der vorhergehenden Ansprüche, **dadurch gekennzeichnet, dass** die Innenwand (53) des Kühlkanals (5) im Bereich der lokalen Oberflächenstruktur (54) eine lokal erhöhte Rauheit aufweist.

5. Kühlvorrichtung nach einem der vorhergehenden Ansprüche, **dadurch gekennzeichnet, dass** die Innenwand (53) des Kühlkanals (5) im Bereich der lokalen Oberflächenstruktur (54) eine höhere Rauheit aufweist als die Innenwand (53) des Kühlkanals (5) an den Umlenksegmenten (52) in dem Umlenkbereich (3).

6. Elektronikanordnung, umfassend:
- ein Bauteil (101), insbesondere ein Halbleiterbauteil, und
- eine Kühlvorrichtung (1) nach einem der vorhergehenden Ansprüche,
- wobei das Bauteil (101) mit einem Grundbereich (2) der Kühlvorrichtung (1) wärmeleitend verbunden ist.

## Claims

1. Cooling device for cooling components (101), comprising:
- a base region (2) which is connectable in a thermally conductive manner to a component (101) to be cooled,
- a diversion region (3),
- an intermediate region (4) between the base region (2) and the diversion region (3), and
- a cooling channel (5) which is of meandering form and has multiple middle segments (51) and multiple diversion segments (52),
- wherein the middle segments (51) each extend from the base region (2) to the diversion region (3),
- wherein the diversion segments (52) each provide a reversal of direction within the base region (2) and within the diversion region (3) and each connect two middle segments (51) to one another,
- wherein the cooling channel (5) is filled with a working medium (6) which is simultaneously gaseous and liquid in the cooling channel (5),
**characterized in that**
an inner wall (53) of the cooling channel (5) has at least one locally limited surface structure (54) which is in contact with the working medium (6), wherein the locally limited surface structure (54) is formed on one side in the diversion segment (52) in the base region (2), with formation of a circulating pulsating flow of the working medium (6) in a preferred direction.

2. Cooling device according to Claim 1, **characterized in that** at least one locally limited surface structure (54) is formed in at least one middle segment (51).

3. Cooling device according to Claim 2, **characterized in that** at least one locally limited surface structure (54) is formed in all the middle segments (51).

4. Cooling device according to one of the preceding claims, **characterized in that** the inner wall (53) of the cooling channel (5) in the region of the local surface structure (54) has locally increased roughness.

5. Cooling device according to one of the preceding claims, **characterized in that** the inner wall (53) of the cooling channel (5) in the region of the local surface structure (54) has greater roughness than the inner wall (53) of the cooling channel (5) at the diversion segments (52) in the diversion region (3).

6. Electronics arrangement comprising:
- a component (101), in particular a semiconductor component, and
- a cooling device (1) according to one of the preceding claims,
- wherein the component (101) is connected in a thermally conductive manner to a base region (2) of the cooling device (1).

## Revendications

1. Dispositif de refroidissement pour refroidir des composants (101), comprenant :
- une région inférieure (2) qui peut être reliée de manière thermoconductrice à un composant (101) à refroidir,
- une région de déviation (3),
- une région intermédiaire (4) entre la région inférieure (2) et la région de déviation (3),
- un canal de refroidissement (5) en forme de méandres et comportant une pluralité de segments centraux (51) et une pluralité de segments de déviation (52),
- chacun des segments centraux (51) s'étendant de la région inférieure (2) à la région de déviation (3),
- les segments de déviation (52) formant respectivement une inversion de direction à l'intérieur de la région inférieure (2) et à l'intérieur de la région de déviation (3) et reliant respectivement l'un à l'autre deux segments centraux (51),
- le canal de refroidissement (5) étant rempli d'un fluide de travail (6) qui se trouve simultanément sous forme gazeuse et liquide dans le canal de refroidissement (5),
**caractérisé en ce que**
une paroi intérieure (53) du canal de refroidissement (5) présente au moins une structure superficielle (54) délimitée localement en contact avec le fluide de travail (6), la structure superficielle (54) délimitée localement étant formée d'un côté dans le segment de déviation (52) dans la région inférieure (2), formant un écoulement pulsé circulant du fluide de travail (6) dans une direction préférée.

2. Dispositif de refroidissement selon la revendication 1, **caractérisé en ce qu'**au moins une structure superficielle (54) délimitée localement est formée dans au moins un segment central (51).

3. Dispositif de refroidissement selon la revendication 2, **caractérisé en ce qu'**au moins une structure superficielle (54) délimitée localement est formée dans tous les segments centraux (51).

4. Dispositif de refroidissement selon l'une des revendications précédentes, **caractérisé en ce que** la paroi intérieure (53) du canal de refroidissement (5) présente une rugosité localement augmentée dans la région de la structure superficielle locale (54).

5. Dispositif de refroidissement selon l'une des revendications précédentes, **caractérisé en ce que** la paroi intérieure (53) du canal de refroidissement (5) présente, dans la région de la structure superficielle locale (54), une rugosité supérieure à celle de la paroi intérieure (53) du canal de refroidissement (5) sur les segments de déviation (52) dans la région de déviation (3).

6. Ensemble électronique, comprenant :
- un composant (101), en particulier un composant semi-conducteur, et
- un dispositif de refroidissement (1) selon l'une des revendications précédentes,
- le composant (101) étant relié de manière thermoconductrice à une région inférieure (2) du dispositif de refroidissement (1).
